# FASCICULE DE BREVET EUROPEEN

(11) **EP 3 811 471 B1**
(45) Date de publication et mention de la délivrance du brevet: **24.07.2024**
(21) Numéro de dépôt: 19730832.3
(22) Date de dépôt: 19.06.2019
(51) Int. Cl.: H01R 13/6584, H01R 13/6599, H05K 3/36, H05K 9/00, H01R 12/73, H05K 1/11

(54) **SYSTEME DE CONNEXION ELECTRIQUE COMPORTANT UN DISPOSITIF DE CONNEXION PRIMAIRE ET UN DISPOSITIF DE CONNEXION SECONDAIRE**
ELEKTRISCHES VERBINDUNGSSYSTEM MIT EINER PRIMÄREN VERBINDUNGSVORRICHTUNG UND EINER SEKUNDÄREN VERBINDUNGSVORRICHTUNG
ELECTRICAL CONNECTION SYSTEM COMPRISING A PRIMARY CONNECTION DEVICE AND A SECONDARY CONNECTION DEVICE

(30) Priorité: 25.06.2018 FR 1855661
(43) Date de publication de la demande: 28.04.2021
(73) Titulaire: Sagemcom Broadband SAS, 92270 Bois-Colombes (FR)
(72) Inventeur: SAHEB, Nassim, 92500 RUEIL MALMAISON (FR); LIEVEN, Hervé, 92500 RUEIL MALMAISON (FR); LE HENANFF, Yann, 92500 RUEIL MALMAISON (FR)
(74) Mandataire: Cabinet Boettcher
(86) Numéro de dépôt international: PCT/EP2019/066306
(87) Numéro de publication internationale: WO 2020/002113

(56) Documents cités:
- WO-A1-2018/049686
- DE-A1- 3 834 182
- FR-A1- 2 508 719
- US-A- 5 145 381
- US-A- 5 292 268
- US-A1- 2003 161 108

## Description

L'invention concerne le domaine des systèmes de connexion électrique comportant un dispositif de connexion primaire et un dispositif de connexion secondaire.

### ARRIERE PLAN DE L'INVENTION

Il est fréquent de concevoir des équipements électriques comprenant deux cartes électriques enfichées entre elles de manière démontable via un système de connexion électrique. La reprise de masse entre les deux cartes électriques, au niveau du système de connexion électrique, est délicate à réaliser de manière fiable et répétable.

Il convient d'éviter que des signaux transmis au travers du système de connexion électrique, et notamment des signaux rapides, ne perturbent le fonctionnement de composants internes de l'équipement électrique qui intègre le système de connexion électrique, ou bien d'équipements électriques externes. Les composants internes et les équipements électriques externes comprennent par exemple des récepteurs radio qui sont donc situés à l'intérieur ou à l'extérieur de l'équipement électrique en question et qui sont susceptibles d'être perturbés par des signaux parasites générés par la transition des signaux rapides entre les deux cartes électriques. La bande de fréquence concernée correspond alors à la bande de travail des récepteurs radio (par exemple jusqu'à 6GHz pour les radios Wi-Fi).

Or, la protection contre la propagation du bruit électromagnétique généré par les signaux transmis dépend de la qualité de la reprise de masse.

Il est connu d'utiliser, pour connecter deux cartes électriques entre elles, une nappe rigide munie à chacune de ses extrémités d'un connecteur, la nappe rigide étant blindée sur toute sa longueur et au niveau des fixations des connecteurs. Une telle nappe rigide est onéreuse et son utilisation est complexe à mettre en oeuvre industriellement.

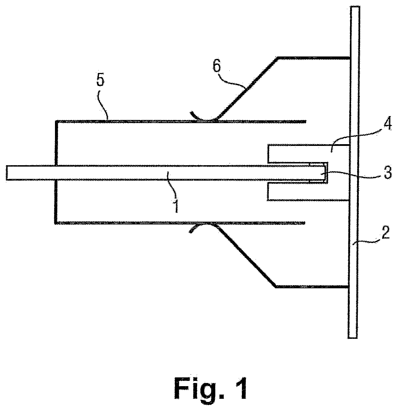

On connaît aussi des systèmes de connexion électrique semblables à celui représenté sur la figure 1, qui est destiné à connecter orthogonalement entre elles une carte électrique primaire 1 et une carte électrique secondaire 2. La carte électrique primaire 1 comprend un connecteur mâle 3 destiné à être connecté à un connecteur femelle 4 de la carte électrique secondaire 2. La carte électrique primaire 1 comprend un dispositif de blindage primaire 5, généralement rigide, et la carte électrique secondaire 2 comprend un dispositif de blindage secondaire 6 comportant une pluralité d'éléments blindés comprenant chacun une portion élastique. Les éléments blindés sont par exemple des doigts parallèles entre eux. Au moment de la connexion entre la carte électrique primaire 1 et la carte électrique secondaire 2, le dispositif de blindage primaire 5 vient glisser et frotter contre les éléments blindés du dispositif de blindage secondaire 6.

Cette solution présente un certain nombre d'inconvénients. Il est nécessaire de prévoir une portion de course suffisante du dispositif de blindage primaire 5 sur les éléments blindés du dispositif de blindage secondaire 6, de manière à assurer un contact suffisant en position connectée. Il existe aussi des contraintes importantes sur la tolérance de fabrication des éléments blindés qui, élastiquement, doivent permettre une insertion aisée du dispositif de blindage primaire 5 tout en assurant un contact suffisant. Par ailleurs, la continuité de contact est généralement mal assurée voire pas du tout assurée au niveau des zones de coin du dispositif de blindage primaire 5 et du dispositif de blindage secondaire 6. Enfin, on note fréquemment la survenue d'un phénomène d'usure, potentiellement problématique, au niveau de l'interface entre le dispositif de blindage primaire 5 et le dispositif de blindage secondaire 6.

Le document US 5 292 268 A divulgue un système de connexion électrique comportant un connecteur primaire et un connecteur secondaire agencés pour être connectés entre eux, et un dispositif de blindage comportant plusieurs éléments blindés pouvant être fixés au connecteur primaire.

Le document US 2003/161108 A1 divulgue un système de connexion électrique comportant un module et un réceptacle. Le réceptacle comprend un cadre de guidage formant une cavité intérieure agencée pour recevoir le module.

### OBJET DE L'INVENTION

L'invention a pour objet un système de connexion électrique qui soit peu encombrant, peu onéreux, robuste, et qui assure de manière fiable et répétable une reprise de masse efficace.

### RESUME DE L'INVENTION

En vue de la réalisation de ce but, on propose un système de connexion électrique comportant un dispositif de connexion primaire et un dispositif de connexion secondaire agencés pour être connectés entre eux, le dispositif de connexion primaire comprenant un capot blindé et des contacts conducteurs primaires qui s'étendent au moins partiellement à l'intérieur du capot blindé, le dispositif de connexion secondaire comprenant une carte électrique secondaire présentant une surface de masse secondaire, des contacts conducteurs secondaires qui s'étendent depuis une surface d'implantation de la carte électrique secondaire entourée par la surface de masse secondaire, et un matériau conducteur élastique fixé sur la surface de masse secondaire, le système de connexion électrique étant agencé de sorte que, lorsque le dispositif de connexion primaire et le dispositif de connexion secondaire sont connectés entre eux, les contacts conducteurs primaires sont connectés électriquement aux contacts conducteurs secondaires à l'intérieur du capot blindé et le capot blindé s'étend sur le matériau conducteur élastique en le comprimant.

Le système de connexion électrique selon l'invention est peu encombrant. Aucun phénomène d'usure n'est constaté. Grâce au capot blindé et au matériau conducteur élastique comprimé par le capot blindé, on obtient un blindage total, très fiable, sans discontinuité de masse. Le contact par compression permet d'obtenir un blindage très efficace quelles que soient les tolérances de fabrication des différents éléments formant le système de connexion électrique.

On propose aussi un équipement électrique comprenant un système de connexion électrique tel que celui qui vient d'être décrit, un circuit primaire relié au dispositif de connexion primaire, et un circuit secondaire relié au dispositif de connexion secondaire.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 représente un système de connexion électrique de l'art antérieur ;
- la figure 2 est une vue en perspective, partiellement éclatée et de face, du système de connexion électrique selon l'invention, le dispositif de connexion primaire et le dispositif de connexion secondaire n'étant pas connectés ;
- la figure 3 est une vue en perspective et de face du système de connexion électrique selon l'invention, le dispositif de connexion primaire et le dispositif de connexion secondaire étant connectés ;
- la figure 4 est une vue en perspective et de côté du système de connexion électrique selon l'invention, le dispositif de connexion primaire et le dispositif de connexion secondaire étant connectés ;
- la figure 5 est une vue en deux dimensions et en section, selon un plan perpendiculaire à une carte électrique primaire et à une carte électrique secondaire, du système de connexion électrique selon l'invention, le dispositif de connexion primaire et le dispositif de connexion secondaire étant connectés ;
- les figures 6 et 7 sont des vues en perspective et de détail d'un bord de la carte électrique primaire comprenant une encoche, le dispositif de connexion primaire et le dispositif de connexion secondaire étant connectés ;
- la figure 8 est une vue en perspective et de dessous du système de connexion électrique selon l'invention, le dispositif de connexion primaire et le dispositif de connexion secondaire étant connectés, des moyens de maintien mécaniques étant représentés.

### DESCRIPTION DETAILLEE DE L'INVENTION

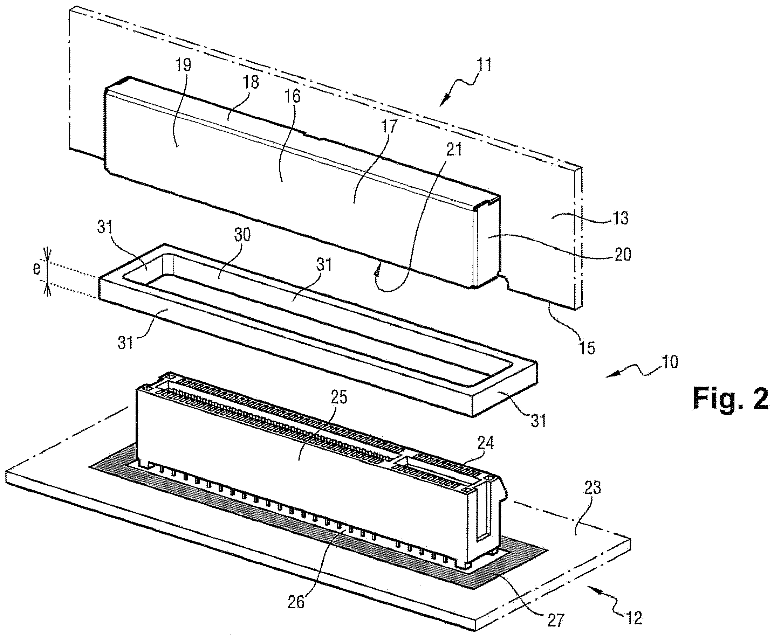

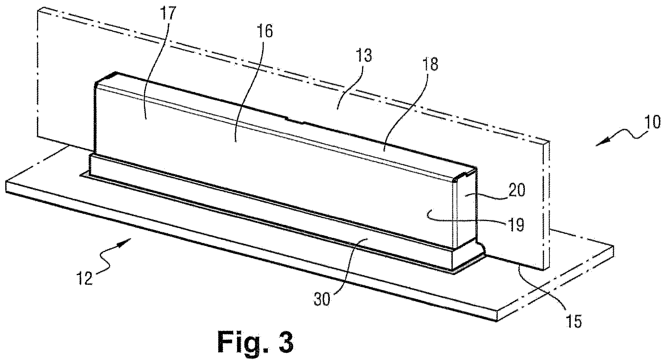

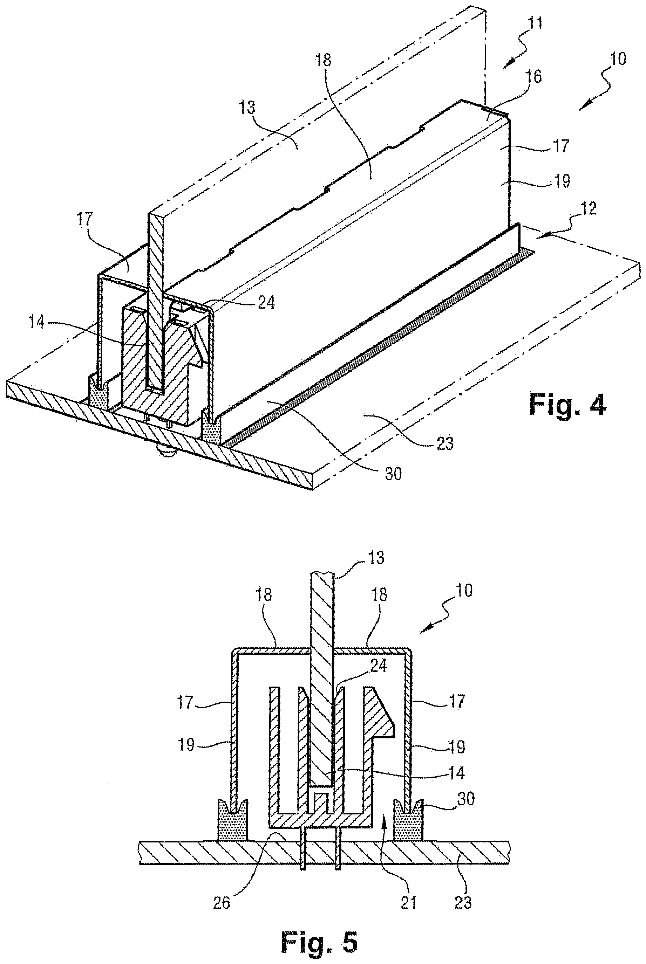

En référence aux figures 2 à 5, le système de connexion électrique selon l'invention 10 comporte un dispositif de connexion primaire 11 et un dispositif de connexion secondaire 12.

Le dispositif de connexion primaire 11 est relié à un circuit primaire. Le dispositif de connexion secondaire 12 est relié à un circuit secondaire.

Le dispositif de connexion primaire 11 et le dispositif de connexion secondaire 12 sont agencés pour être connectés entre eux, de façon démontable, pour pouvoir connecter entre eux le circuit primaire et le circuit secondaire. Le circuit primaire et le circuit secondaire peuvent ainsi échanger des signaux (alimentation, données, etc.) au travers du système de connexion électrique 10.

Le circuit primaire, le circuit secondaire et le système de connexion électrique 10 sont destinés à être intégrés dans un même équipement électrique, le dispositif de connexion primaire 11 et le dispositif de connexion secondaire 12 étant alors connectés entre eux.

Le dispositif de connexion primaire 11 comporte tout d'abord une carte électrique primaire 13. Ici, le circuit primaire est disposé sur la carte électrique primaire 13.

La carte électrique primaire 13 porte des contacts conducteurs primaires 14 sur lesquels des signaux sont susceptibles de cheminer. Les contacts conducteurs primaires 14 s'étendent parallèlement à la carte électrique primaire 13 au niveau d'un bord 15 de la carte électrique primaire 13.

Le dispositif de connexion primaire 11 comporte de plus un capot blindé 16 rigide fabriqué en un matériau électriquement conducteur, par exemple en cuivre ou en acier.

Le capot blindé 16 comprend ici deux demi-coques 17 qui s'étendent chacune d'un côté de la carte électrique primaire 13.

Chaque demi-coque 17 comprend une face supérieure 18 orthogonale à la carte électrique primaire 13 et parallèle au bord 15, une face principale 19 parallèle à la carte électrique primaire 13, et deux faces latérales 20 qui sont chacune orthogonales à la carte électrique primaire 13 et au bord 15.

Le capot blindé 16, pris dans son intégralité, forme ainsi un caisson blindé parallélépipédique ouvert uniquement au niveau d'une face d'ouverture vide 21 parallèle aux faces supérieures 18.

Le capot blindé 16 s'étend partiellement en saillie de la carte électrique primaire 13, c'est-à-dire qu'une portion de la face principale 19 et des faces latérales 20 de chaque demi-coque 17 dépasse du bord de la carte électrique primaire 13.

Le capot blindé 16 est fixé à la carte électrique primaire 13. Ici, en l'occurrence, la face supérieure 18 et les faces latérales 20 de chaque demi-coque 17 du capot blindé 16 sont fixées par refusion sur une face distincte de la carte électrique primaire 13. Bien sûr, un autre moyen de fixation pourrait être utilisé : autre type de soudage, clipsage, vissage, etc.

Avantageusement, la face supérieure 18 et les faces latérales 20 de chaque demi-coque 17 sont chacune fixées contre une surface de masse primaire, chaque surface de masse primaire s'étendant sur une face distincte de la carte électrique primaire 13. Chaque surface de masse primaire est par exemple une surface métallique nue (c'est-à-dire non vernie et non revêtue).

Les contacts conducteurs primaires 14 s'étendent au moins partiellement, ici entièrement, à l'intérieur du capot blindé 16.

Le dispositif de connexion secondaire 12, quant à lui, comporte tout d'abord une carte électrique secondaire 23. Ici, le circuit secondaire est disposé sur la carte électrique secondaire 23.

La carte électrique secondaire 23 porte des contacts conducteurs secondaires 24 sur lesquels des signaux sont susceptibles de cheminer. Les contacts conducteurs secondaires 24 s'étendent orthogonalement à la carte électrique secondaire 23.

Les contacts conducteurs secondaires 24 sont disposés dans un connecteur secondaire 25, ici un connecteur pour signaux rapides, et s'étendent depuis une surface d'implantation 26 de la carte électrique secondaire 23.

La carte électrique secondaire 23 comporte une surface de masse secondaire 27 qui est une surface métallique nue. La surface de masse secondaire 27 présente la forme d'un ruban qui s'étend sur une face de la carte électrique secondaire 23 pour former un rectangle.

La surface de masse secondaire 27 entoure la surface d'implantation 26 et donc les contacts conducteurs secondaires 24.

Le dispositif de connexion secondaire 12 comporte de plus un matériau conducteur élastique 30.

Le matériau conducteur élastique 30 présente ici la forme d'un profilé rectangulaire, c'est-à-dire qu'il a une forme tubulaire de section rectangulaire.

Le matériau conducteur élastique 30 comporte quatre branches 31 ayant chacune une section rectangulaire et entourant une cavité interne de section rectangulaire. L'épaisseur e de chaque branche 31 est ici égale à 3mm.

Le matériau conducteur élastique 30 comprend ici une mousse conductrice.

Le matériau conducteur élastique 30 est fixé sur la surface de masse secondaire 27, ici par collage à l'aide d'une colle conductrice. Bien sûr, un autre moyen de fixation pourrait être utilisé : clipsage, vissage, etc.

Le connecteur secondaire 25 et les contacts conducteurs secondaires 24 s'étendent donc, au niveau de leur base, dans la cavité interne du matériau conducteur élastique 30.

Ainsi, lors de la connexion entre eux du dispositif de connexion primaire 11 et du dispositif de connexion secondaire 12, le connecteur secondaire 25 pénètre dans le capot blindé 16 via la face d'ouverture vide 21. Les contacts conducteurs primaires 14 et les contacts conducteurs secondaires 24 sont alors en contact les uns avec les autres et permettent ainsi la transmission de signaux entre le dispositif de connexion primaire 11 et le dispositif de connexion secondaire 12, et donc entre le circuit primaire et le circuit secondaire. On note que la connexion électrique est ici réalisée par contact, mais qu'une connexion par couplage sans contact serait également possible.

Le capot blindé 16, rigide, s'étend alors sur le matériau conducteur élastique 30 en le comprimant. On obtient donc une continuité parfaite de masse du blindage sur tout le contour du capot blindé 16, c'est-à-dire sur la totalité des bords libres des faces principales 19 et des faces latérales 20 des deux demi-coques 17 du capot blindé 16. La continuité est aussi assurée au niveau des coins du capot blindé 16 et du matériau conducteur élastique 30.

Le capot blindé 16 (ainsi, le cas échéant, que la surface de masse primaire) est donc en contact électrique parfaitement continu avec le matériau conducteur élastique 30 et avec la surface de masse secondaire 27.

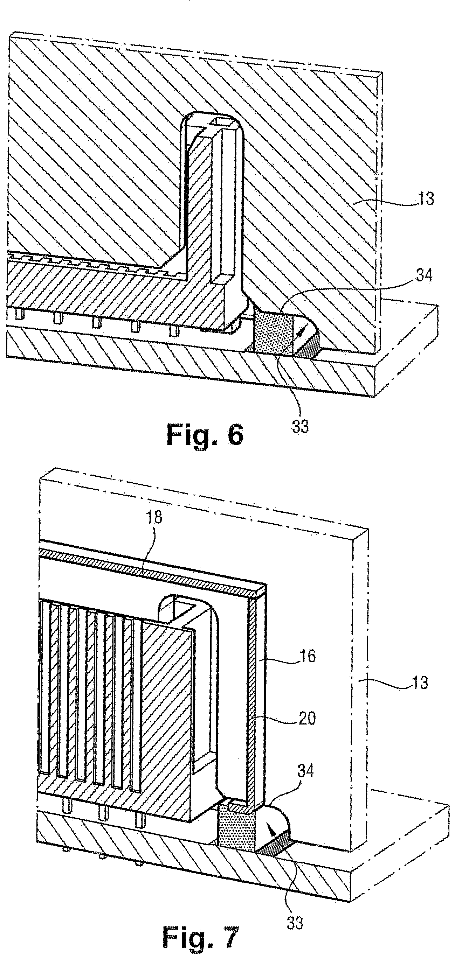

On remarque sur les figures 6 et 7 que le bord 15 de la carte électrique primaire 13 présente au moins une encoche 33. Ici, le bord 15 de la carte électrique primaire comporte deux encoches 33. Chaque encoche 33 est située sur le bord 15 à proximité d'une surface de contact entre le capot blindé 16 et la carte électrique primaire 13, c'est-à-dire sur le bord 15 à proximité des bords libres des faces latérales 20 des demi-coques 17 du capot blindé 16. Chaque encoche 33 est formée à partir d'un bord libre de deux faces latérales 20 situées de part et d'autre de la carte électrique primaire 13, c'est-à-dire que, dans chaque encoche 33, la tranche 34 de la carte électrique primaire 13 vient affleurer le bord libre de deux faces latérales 20 situées de part et d'autre de la carte électrique primaire 13.

La tranche 34 de la carte électrique primaire 13, dans les encoches 33, est revêtue d'un matériau métallique qui est relié à un plan de masse de la carte électrique primaire 13.

Grâce à ces encoches 33, lorsque le dispositif de connexion primaire 11 et le dispositif de connexion secondaire 12 sont connectés, le bord 15 de la carte électrique primaire 13 peut venir en appui contre la carte électrique secondaire 23 tout en limitant la compression du matériau conducteur élastique 30 par le bord 15.

On dégage ainsi le matériau conducteur électrique 30 de toute contrainte excessive créée par la tranche 34 de la carte électrique primaire 13. Comme cette tranche 34, dans chaque encoche 33, est placée au même niveau que le capot blindé 16, c'est-à-dire au même niveau que les bords libres des faces latérales 20 des demi-coques 17, la tranche 34 comprime le matériau conducteur élastique 30 de la même manière que le reste du capot de blindage 16. De plus, grâce au contact entre le matériau métallique revêtant la tranche 34 et le matériau conducteur électrique 30, on limite (voire même on supprime) les fuites de rayonnement dans cette zone singulière.

On note que le matériau conducteur élastique 30 est conducteur pour assurer la continuité de masse du blindage du système de connexion électrique 10, et est élastique pour permettre au capot blindé 16 de la carte électrique primaire 13 d'être en contact avec le matériau conducteur élastique 30 sur tout le contour du capot blindé 16.

La mousse utilisée doit être assez élastique pour subir une déformation non permanente afin de toujours établir le contact entre le capot blindé 16 et la mousse (et donc entre le capot blindé 16 et la surface de masse secondaire 27 de la carte électrique secondaire 23). La mousse choisie ici présente un taux de compression de 33%. Comme le matériau conducteur élastique 30 a une épaisseur de 3mm, on obtient une tolérance de course du capot blindé 16 de 1mm. Le taux de compression ne doit pas être trop faible pour bien assurer le contact sur tout le contour, et ne doit pas non plus être trop élevé pour ne pas déformer la carte électrique secondaire 23 d'une part, et pour ne pas perdre l'élasticité de la mousse d'autre part.

La mousse choisie permet d'atteindre une efficacité de blindage supérieure à 100dB pour des signaux de fréquence jusqu'à 8GHz au travers d'un matériau de forte conductivité.

Le système de connexion électrique 10 entre la carte électrique primaire 13 et la carte électrique secondaire 23 est mis en contrainte par la force de résilience de la mousse. Cette force tend à éloigner la carte électrique primaire 13 de la carte électrique secondaire 23 et donc à provoquer la déconnexion de la carte électrique primaire 13 et de la carte électrique secondaire 23. La raideur de la mousse doit être dimensionnée pour prendre en compte ce paramètre.

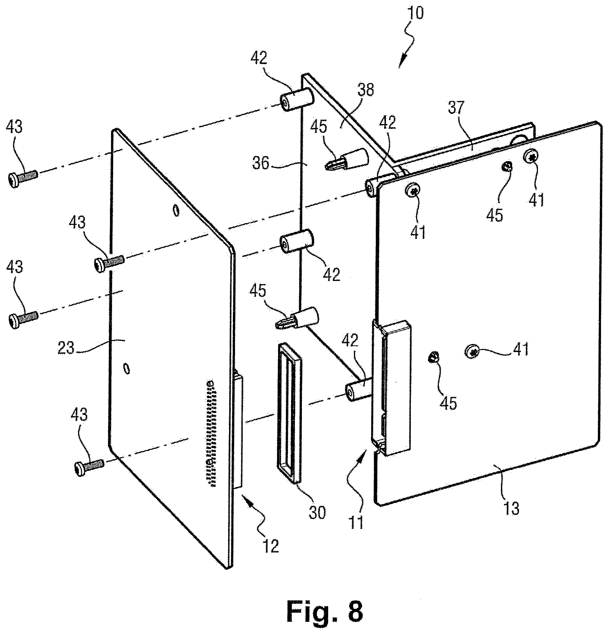

Avantageusement (mais non nécessairement), en référence à la figure 8, le système de connexion électrique 10 comporte de plus des moyens de maintien mécanique de la carte électrique primaire 13 et de la carte électrique secondaire 23.

Les moyens de maintien mécanique comprennent ici un dispositif de maintien 36 comportant une plaque primaire 37 et une plaque secondaire 38 qui sont orthogonales entre elles. Le dispositif de maintien 36 est destiné à être positionné contre la carte électrique primaire 13 et la carte électrique secondaire 23, à l'intérieur de l'espace délimité par la carte électrique primaire 13 et la carte électrique secondaire 23.

La plaque primaire 37 est agencée pour être fixée à la carte électrique primaire 13 et comporte à cet effet des plots filetés 40 sur sa face externe. La fixation de la plaque primaire 37 et de la carte électrique primaire 13 est réalisées grâce à des vis 41 qui traversent la carte électrique primaire 13 pour être vissées dans les plots filetés 40.

La plaque secondaire 38 est agencée pour être fixée à la carte électrique secondaire 23 et comporte à cet effet des plots filetés 42 sur sa face externe. La fixation de la plaque secondaire 38 et de la carte électrique secondaire 23 est réalisées grâce à des vis 43 qui traversent la carte électrique secondaire 23 pour être vissées dans les plots filetés 42.

Le dispositif de maintien comprend de plus des index 45 prenant la forme de pions mâles insérés dans des trous formés dans la carte électrique primaire 13 et dans la carte électrique secondaire 23. Ces index 45 permettent de positionner précisément la carte électrique primaire 13 et la carte électrique secondaire 23 l'une par rapport à l'autre.

Ainsi, le dispositif de maintien permet de maintenir et de positionner parfaitement la carte électrique primaire 13 et la carte électrique secondaire 23 l'une par rapport à l'autre et de garantir leur position connectée.

Le dispositif de maintien est ici fabriqué en un matériau métallique et joue par ailleurs le rôle d'un dissipateur thermique qui dissipe une chaleur produite par des composants du circuit primaire et du circuit secondaire.

On note que le dispositif de maintien pourrait être réalisé sous une autre forme, par exemple via un système de clips qui maintiennent le capot blindé 16 en appui sur le matériau conducteur électrique 30.

Bien entendu, l'invention n'est pas limitée au mode de réalisation décrit mais englobe toute variante entrant dans le champ de l'invention telle que définie par les revendications.

On a indiqué ici que le capot blindé comporte deux demi-coques. Le capot blindé pourrait avoir une forme et/ou une structure différentes. Par exemple, le capot blindé pourrait comprendre une seule demi-coque qui s'étend d'un côté de la carte électrique primaire, et une surface blindée qui s'étend sur une face de la carte électrique primaire du côté où est située la demi-coque. La surface blindée s'étend alors parallèlement et en regard de la face principale de la demi-coque. La demi-coque et la surface blindée forment alors à nouveau un caisson blindé parallélépipédique ouvert uniquement au niveau d'une face d'ouverture vide.

Le matériau conducteur élastique ne comporte pas nécessairement une mousse mais pourrait comprendre un matériau différent, par exemple un profilé de polymère élastique, solide et conducteur, de section quelconque.

Le dispositif de connexion primaire ne comporte pas nécessairement une carte électrique primaire : les contacts conducteurs primaires pourraient par exemple être reliés à des fils d'un câble ou d'une nappe, le capot blindé s'étendant alors autour de l'extrémité du câble ou de la nappe.

## Revendications

1. Système de connexion électrique comportant un dispositif de connexion primaire (11) et un dispositif de connexion secondaire (12) agencés pour être connectés entre eux, le dispositif de connexion primaire comprenant un capot blindé (16) et des contacts conducteurs primaires (14) qui s'étendent au moins partiellement à l'intérieur du capot blindé, le dispositif de connexion secondaire (12) comprenant une carte électrique secondaire (23) présentant une surface de masse secondaire (27), des contacts conducteurs secondaires (24) qui s'étendent depuis une surface d'implantation (26) de la carte électrique secondaire entourée par la surface de masse secondaire, et un matériau conducteur élastique (30) fixé sur la surface de masse secondaire, le système de connexion électrique (10) étant agencé de sorte que, lorsque le dispositif de connexion primaire et le dispositif de connexion secondaire sont connectés entre eux, les contacts conducteurs primaires sont connectés électriquement aux contacts conducteurs secondaires à l'intérieur du capot blindé et le capot blindé s'étend sur le matériau conducteur élastique en le comprimant.

2. Système de connexion électrique selon la revendication 1, dans lequel le dispositif de connexion primaire comprend une carte électrique primaire (13) portant les contacts conducteurs primaires (14) et sur laquelle est fixé le capot blindé (16).

3. Système de connexion électrique selon la revendication 2, dans lequel le capot blindé comprend deux demi-coques (17) qui s'étendent chacune d'un côté de la carte électrique primaire.

4. Système de connexion électrique selon la revendication 2, dans lequel le capot blindé comprend une demi-coque qui s'étend d'un côté de la carte électrique primaire, et une surface blindée qui s'étend sur la carte électrique primaire en regard d'une face de la demi-coque.

5. Système de connexion électrique selon l'une des revendications 2 à 4, dans lequel les contacts conducteurs primaires (14) s'étendent parallèlement à la carte électrique primaire (13), les contacts conducteurs secondaires (24) s'étendent orthogonalement à la carte électrique secondaire (23), la carte électrique primaire et la carte électrique secondaire étant disposées orthogonalement l'une par rapport à l'autre lorsque le dispositif de connexion primaire (11) et le dispositif de connexion secondaire (12) sont connectés entre eux.

6. Système de connexion électrique selon l'une des revendications 2 à 5, dans lequel un bord (15) de la carte électrique primaire comprend au moins une encoche (33) agencée de sorte que, lorsque le dispositif de connexion primaire et le dispositif de connexion secondaire sont connectés entre eux, le bord (15) de la carte électrique primaire soit en appui contre la carte électrique secondaire tout en limitant la compression du matériau conducteur élastique (30) par le bord (15).

7. Système de connexion électrique selon l'une des revendications précédentes, dans lequel le matériau conducteur élastique (30) comprend une mousse conductrice.

8. Equipement électrique comprenant un système de connexion électrique (10) selon l'une des revendications précédentes, un circuit primaire relié au dispositif de connexion primaire (11), et un circuit secondaire relié au dispositif de connexion secondaire (12) .

## Patentansprüche

1. Elektrisches Verbindungssystem, umfassend eine primäre Verbindungsvorrichtung (11) und eine sekundäre Verbindungsvorrichtung (12), die ausgebildet sind, miteinander verbunden zu werden, wobei die primäre Verbindungsvorrichtung eine abgeschirmte Kappe (16) und primäre leitende Kontakte (14) umfasst, die sich zumindest teilweise im Inneren der abgeschirmten Kappe erstrecken, wobei die sekundäre Verbindungsvorrichtung (12) eine sekundäre Leiterplatte (23) umfasst, die eine sekundäre Massefläche (27) aufweist, sekundäre leitende Kontakte (24), die sich ab einer Implantationsfläche (26) der sekundären Leiterplatte erstrecken, die von der sekundären Massefläche umgeben ist, sowie ein elastisches leitendes Material (30), das auf der sekundären Massefläche befestigt ist, wobei das elektrische Verbindungssystem (10) derart ausgebildet ist, dass, wenn die primäre Verbindungsvorrichtung und die sekundäre Verbindungsvorrichtung miteinander verbunden sind, die primären leitenden Kontakte elektrisch mit den sekundären leitenden Kontakten im Inneren der abgeschirmten Kappe verbunden sind und sich die abgeschirmte Kappe auf dem elastischen leitenden Material erstreckt, während es dieses komprimiert.

2. Elektrisches Verbindungssystem nach Anspruch 1, bei dem die primäre Verbindungsvorrichtung eine primäre Leiterplatte (13) umfasst, die die primären leitenden Kontakte (14) trägt und auf der die abgeschirmte Kappe (16) befestigt ist.

3. Elektrisches Verbindungssystem nach Anspruch 2, bei dem die abgeschirmte Kappe zwei Halbschalen (17) umfasst, die sich jeweils auf einer Seite der primären Leiterplatte erstrecken.

4. Elektrisches Verbindungssystem nach Anspruch 2, bei dem die abgeschirmte Kappe eine Halbschale umfasst, die sich auf einer Seite der primären Leiterplatte erstreckt, und eine abgeschirmte Fläche, die sich auf der primären Leiterplatte gegenüber einer Fläche der Halbschale erstreckt.

5. Elektrisches Verbindungssystem nach einem der Ansprüche 2 bis 4, bei dem sich die primären leitenden Kontakte (14) parallel zur primären Leiterplatte (13) erstrecken, sich die sekundären leitenden Kontakte (24) orthogonal zur sekundären Leiterplatte (23) erstrecken, wobei die primäre Leiterplatte und die sekundäre Leiterplatte orthogonal zueinander angeordnet sind, wenn die primäre Verbindungsvorrichtung (11) und die sekundäre Verbindungsvorrichtung (12) miteinander verbunden sind.

6. Elektrisches Verbindungssystem nach einem der Ansprüche 2 bis 5, bei dem ein Rand (15) der primären Leiterplatte mindestens eine Kerbe (33) umfasst, die derart ausgebildet ist, dass, wenn die primäre Verbindungsvorrichtung und die sekundäre Verbindungsvorrichtung miteinander verbunden sind, der Rand (15) der primären Leiterplatte an der sekundären Leiterplatte anliegt, während die Kompression des elastischen leitenden Materials (30) durch den Rand (15) begrenzt wird.

7. Elektrisches Verbindungssystem nach einem der vorhergehenden Ansprüche, bei dem das elastische leitende Material (30) einen leitenden Schaumstoff umfasst.

8. Elektrische Ausrüstung, umfassend ein elektrisches Verbindungssystem (10) nach einem der vorhergehenden Ansprüche, einen primären Schaltkreis, der mit der primären Verbindungsvorrichtung (11) verbunden ist, und einen sekundären Schaltkreis, der mit der sekundären Verbindungsvorrichtung (12) verbunden ist.

## Claims

1. An electrical connection system comprising a primary connection device (11) and a secondary connection device (12) arranged to be connected together, the primary connection device including a shielded cover (16) and primary conductive contacts (14) that extend at least in part inside the shielded cover, the secondary connection device (12) including a secondary electric circuit card (23) presenting a secondary ground surface (27), secondary conductive contacts (24) that extend from an implantation surface (26) of the secondary circuit card, which implantation surface is surrounded by the secondary ground surface, and a compliant conductive material (30) fastened on the secondary ground surface, the electrical connection system (10) being arranged in such a manner that, when the primary connection device and the secondary connection device are connected together, the primary conductive contacts are electrically connected to the secondary conductive contacts inside the shielded cover and the shielded cover extends over the compliant conductive material while compressing it.

2. An electrical connection system according to claim 1, wherein the primary connection device includes a primary electric circuit card (13) carrying the primary conductive contacts (14) and on which the shielded cover (16) is fastened.

3. An electrical connection system according to claim 2, wherein the shielded cover comprises two half-shells (17), each extending on a respective side of the primary circuit card.

4. An electrical connection system according to claim 2, wherein the shielded cover comprises a half-shell that extends on one side of the primary circuit card, together with a shielded surface that extends over the primary circuit card facing a face of the half-shell.

5. An electrical connection system according to any one of claims 2 to 4, wherein the primary conductive contacts (14) extend parallel to the primary circuit card (13), the secondary conductive contacts (24) extend orthogonally to the secondary circuit card (23), the primary circuit card and the secondary circuit card being arranged orthogonally relative to each other when the primary connection device (11) and the secondary connection device (12) are connected together.

6. An electrical connection system according to any one of claims 2 to 5, wherein an edge (15) of the primary circuit card includes at least one notch (33) arranged in such a manner that, when the primary connection device and the secondary connection device are connected together, the edge (15) of the primary circuit card bears against the secondary circuit card while limiting the extent to which the compliant conductive material (30) is compressed by the edge (15).

7. An electrical connection system according to any preceding claim, wherein the compliant conductive material (30) comprises a conductive foam.

8. Electrical equipment comprising an electrical connection system (10) according to any preceding claim, a primary circuit connected to the primary connection device (11), and a secondary circuit connected to the secondary connection device (12).
